# EUROPEAN PATENT APPLICATION

(11) **EP 4 106 504 A1**
(43) Date of publication of application: **21.12.2022**
(21) Application number: 21179461.5
(22) Date of filing: 15.06.2021
(51) Int. Cl.: H05K 7/14

(54) **ENCAPSULATED CONVERTER CELL MODULE**

(71) Applicant: Hitachi Energy Switzerland AG, 5400 Baden (CH)
(72) Inventor: Arevalo, Liliana, 771 42 Ludvika (SE); Wu, Dong, 771 43 Ludvika (SE); Hedblad, Per-Olov, 771 92 Ludvika (SE)
(74) Representative: AWA Sweden AB

(57) **Abstract**

A converter cell module for a power converter valve of a High Voltage Direct Current, HVDC, transmission system or a Flexible Alternating Current Transmission System, FACTS, is provided. The power converter valve includes a plurality of converter cell modules electrically connected to each other. The converter cell module comprises an enclosure at least partially filled with an insulation fluid, an electrical energy storage medium for storing energy associated with the converter cell module, connectors arranged through the enclosure and configured for electrical connection of electrical terminals of the converter cell module to at least another converter cell module of the valve, and a switching module arranged to connect the electrical energy storage medium to the electrical terminals. At least the switching module is arranged within the enclosure. Further, the insulation fluid are configured to provide electrical insulation within the enclosure up to an overvoltage of the converter cell module, wherein the overvoltage is higher than an operating voltage of the converter cell module and lower than a voltage across the power converter valve.

## Description

### Technical Field

The present disclosure generally relates to the field of power transmission systems. More specifically, the present disclosure relates to a converter cell module for a power converter valve of a High Voltage Direct Current (HVDC) transmission system or a Flexible Alternating Current Transmission System (FACTS).

### Background

HVDC transmission systems and FACTSs rely on the use of power converters. Within HVDC transmission systems and FACTSs, both current-source converters (CSCs) and voltage-source converters (VSCs) are currently being used. CSCs and VSCs include interconnected converter cell modules, wherein the interconnected converter cell modules form valves of a converter (or converter station). The insulation medium used in such valves is usually air, which may act as the main insulation for an entire valve of the converter.

The prior art comprises converter stations arranged indoors, for example inside a large converter hall, wherein the indoor air acts as the main insulation medium for the converter station. The cost of such installations is however quite high, and such installations require also the use of long wall bushing in order to interconnect equipment inside the structure with equipment outside of the structure and special equipment to control environmental conditions in the hall.

Other known solutions comprise placing an entire valve, or valve arm, of a converter in a container comprising an insulating fluid. However, such constructions are complex to install, repair and maintain.

In light of the above, there is therefore a need for power converters which are more easily installable, more easily maintainable and/or which provide an increased performance.

### Summary

To at least partially fulfil the above requirements, the present disclosure seeks to provide at least an improved converter cell module for a power converter valve and a power converter arrangement comprising a valve which comprises a plurality of such improved converter cell modules.

To achieve this, a converter cell module as defined in the independent claim is provided. Further embodiments of the present disclosure are provided in the dependent claims.

According to a first aspect, a converter cell module for a power converter valve of a High Voltage Direct Current, HVDC, transmission system or a Flexible Alternating Current Transmission System, FACTS, is provided. The power converter valve includes a plurality of converter cell modules electrically connected to each other. The converter cell module comprises an enclosure at least partially filled with an insulation fluid. The converter cell module further comprises an electrical energy storage medium for storing energy associated with the converter cell module. The converter cell module further comprises connectors arranged through the enclosure and configured for electrical connection of electrical terminals of the converter cell module to at least another converter cell module of the valve. The converter cell module further comprises a switching module arranged to connect the electrical energy storage medium to the electrical terminals. At least the switching module is arranged within the enclosure and the insulation fluid is configured to provide electrical insulation within the enclosure up to an overvoltage of the converter cell module. The overvoltage is higher than an operating voltage of the converter cell module and lower than a voltage across the power converter valve.

According to a second aspect, a power converter arrangement is provided. The power converter arrangement comprises a valve comprising a plurality of converter cell modules as defined according to the first aspect. The plurality of converter cell modules is electrically connected to each other. The power converter arrangement further comprises a structure configured to support the plurality of converter cell modules at a distance from a grounding surface (i.e. a surface having a ground potential or a zero potential).

The power converter arrangement may interchangeably be referred to as a power converter station, a power converter valve or, more generally, a power converter.

The converter cell module may be understood as comprising a converter cell and an enclosure, wherein the converter cell comprises the electrical energy storage medium, the connectors, and the switching module. The enclosure may be understood as, for example, an encapsulation, a container, or a sealed container. A converter cell module may comprise at least one converter cell. Preferably, a converter cell module comprises one or two converters cells. Most preferably, a converter cell module comprises one converter cell.

By the term "overvoltage of the converter cell module", it is meant, for example, a voltage in a circuit, part of a circuit, or a component, of the converter cell module which is raised above its upper design limit or maximum operating voltage, or a voltage spike. The insulation fluid may be configured to provide electrical insulation within the enclosure up to a maximum overvoltage of the converter cell module. The operating voltage of the converter cell may be a fraction of the overvoltage of the converter cell module. For example, the operating voltage may be a half, a third, or a fourth, of the overvoltage. In other words, the operating voltage may for example be between 25% and 50% of the overvoltage. Further, the overvoltage of the converter cell may be a fraction of a voltage across the power converter valve. The overvoltage may be between 10% and 30% of a voltage across the power converter valve, depending on the number of converter cell modules required to make the power converter valve.

The enclosure may be configured to prevent the insulation fluid from exiting the enclosure.

For a power converter of the prior art, in which at least an entire valve arm (or valve) is arranged inside a structure, in case of a malfunction, such as an explosion, or damage, of a component of a valve, fume and/or particles may be discharged by the malfunctioning component to the air surrounding other parts of the valve. The fume and/or particles of a malfunctioning component may negatively affect the insulation properties of the surrounding air, and thus also neighboring components, with the consequence, or at least the risk, that the entire converter, or the entire converter station, may have to be taken out of operation. Continuous operation of such a converter station comes at the price of such a risk.

The electrical insulation provided by the enclosure of individual power converter cell modules may reduce the risk of a malfunctioning converter cell module causing other parts (such as other converter cell modules), or the whole, of the valve or power converter comprising such a malfunctioning converter cell module to become inoperable. In other words, the converter cell module may contain (or enclose) the fume and/or particles caused by a malfunctioning converter cell module.

The connectors may be arranged through walls of the enclosure. The connectors are arranged such that the terminals of the converter cell module are electrically insulated. Electrical insulation of the terminal may be done by, for example, the connectors including electrically insulating bushings as described below, or by the enclosure comprising an electrically insulating material through which the connectors are arranged. The connectors may be arranged through the enclosure in a fluid-tight manner. In other words, the connectors may be arranged through the enclosure such that the insulation may not exit the enclosure. The connectors may be arranged through apertures of the enclosure. The connectors may be arranged through the enclosure such that the insulation fluid may not exit via the apertures through which the connectors are arranged. The apertures may be sealed with regards to the electrically insulating bushings such that the insulation fluid may not exit via the apertures.

Converter cell modules of a converter (or converter valve) may be operating at different electrical potentials, hence the potential between converter cell modules of a power converter valve may be in the high voltage range, such as voltages above a few kV and more specifically above 50 kV or above 100 kV. In other words, voltages across a power converter valve may be in the high voltage range, such as voltages above for example 50 or 100 kV. Operating voltages within a converter cell module (e.g. an operating voltage of the converter cell module) may be a fraction of voltages across a power converter valve. Therefore, in order to electrically insulate a power converter valve, the electrical insulation between converter cell modules of the power converter valve, which may be understood as electrical insulation exterior to the enclosure of the power converter module, may be configured to provide electrical insulation for high voltages, such as voltages above 100 kV. If gas or liquid is used to provide such an external electrical insulation for high voltages, there needs to be a large quantity of gas or liquid in order to insulate the entire valve.

The converter cell module comprising an enclosure at least partially filled with an insulation fluid may only need to insulate a volume sufficiently large to comprise a converter cell (i.e. electrical components of a converter cell module). Thereby, the amount of insulation fluid may be decreased in comparison to a power converter in which an entire valve is insulated by gas or liquid. As the present concept requires only to insulate a relatively small volume (i.e. the volume of the converter cell module) as compared to systems in which the entire valve needs to be insulated, the requirements on the insulation medium are lowered, in particular with respect to the overvoltage it is expected to withstand. In other words, for lower voltage levels, lower volumes of insulation gas are necessary and other types of gases can be used. As such, the present concept is beneficial in that it reduces the risk of an environmental impact.

If a converter cell of a power converter valve, which uses gas or liquid to insulate the entire valve or a portion of the valve (i.e. a valve arm or a valve leg, which comprises a plurality of converter cells), malfunctions or requires maintenance, then the gas or liquid may have to be emptied from the entire valve before reparation or replacement of the malfunctioning converter cell, or before maintenance. This is time-consuming, costly and environmentally unfriendly. Additionally, the entire valve or portion of the valve comprising the malfunctioning converter cell becomes inoperable until the malfunctioning converter cell is repaired, replaced or until maintenance has been performed.

Further, a converter cell module having its own (or a dedicated) enclosure at least partially filled with an insulation fluid for electrically insulating the components of the converter cell module, wherein the insulation fluid is configured to provide electrical insulation within the enclosure up to an overvoltage of the converter cell module, allows for the replacement of a single converter cell module in a valve including a plurality of such converter cell modules electrically connected to each other. As a result, maintainability, and consequently reliability, is increased.

Upon a malfunction of one converter cell module, only the malfunctioning converter cell module may need to be replaced or repaired. Hence, rather than having to replace the entire valve, a single converter cell module may need to be replaced. Due to the smaller size and/or cost of a converter cell module in relation to a valve of a converter, spare converter cell modules can be kept at the location of the converter station comprising the converter. Thereby, operation downtime may be greatly reduced.

In a valve arranged inside a converter hall, the components of the valve are exposed to the ambient air conditions, such as humidity, temperature and/or pollution, of the converter hall. Therefore, the converter hall needs to be operated under controlled conditions, such as at a specific air/gas temperature and/or humidity.

The converter cell module according to the first aspect may allow for outdoor installation of a power converter valve in that the converter module includes an enclosure in which the switching module of the converter module is arranged, thereby providing protection from outdoor environment. As such, the converter cell module according to the first aspect is beneficial in that a power converter valve (or power converter station) may be installed without the need of a building or a hall, and the need of controlling air conditions within such a building or hall.

The electrical energy storage medium may be a capacitor. Further, the switching module may include at least two power semiconductor switches electrically connected with the capacitor in the form of a half-bridge circuit or a full-bridge circuit. The switching module may include two power semiconductor switches electrically connected with the capacitor in the form of a half-bridge circuit. The switching module may include four power semiconductor switches electrically connected with the capacitor in the form of a full-bridge circuit. By the term "a full-bridge circuit" it is further meant, for example, a H-bridge circuit. The power semiconductor switches may be, for example thyristors, transistors, or insulated-gate bipolar transistors (IGBTs). However, the switching module is not limited to comprising two or four power semiconductor switches, and it may instead comprise any number of semiconductor switches.

In some embodiments, the electrical energy storage medium may be arranged within the enclosure. Hence, the electrical storage medium may also be protected from the ambient (i.e. outdoor) environment, which may further increase the reliability of the converter cell module.

In other embodiments, the electrical energy storage medium may be arranged outside of the enclosure, in order to reduce the size of the enclosure.

The converter cell module may further comprise at least one of a control unit configured to control the switching module, a bypass switch, a direct current/direct current (DC/DC) converter, communication means for communicating with at least another converter cell module, and/or a resistance. The converter cell module may be understood as comprising an enclosure and a converter cell, wherein the converter cell comprises the switching module, and at least one of a control unit configured to control the switching module, a bypass switch, a DC/DC converter, communication means for communicating with at least another converter cell module, and/or a resistance. Further, the converter cell module may comprise more than one of a control unit configured to control the switching module, a bypass switch, a DC/DC converter, communication means for communicating with at least another converter cell module, and/or a resistance. For example, the converter cell module may comprise a plurality of resistances.

The insulation fluid may be a gas comprising at least one of pressurized air, synthetic air, CO₂, N₂, N₂-SF₆, CO₂-SF₆, or any combination thereof. The gas may be at a predetermined pressure. For example, the gas may be at atmospheric pressure or below atmospheric pressure. The enclosure may be sealed. In other words, the enclosure may be air-tight, gas-tight or fluid-tight such that the gas, and the gas pressure, may be maintained within the enclosure.

The insulation fluid may be a liquid. The liquid may be, for example, oil, deionized water, or a combination thereof. The oil may for example comprise at least one of mineral oil, silicone-based oil and bio-based oil.The enclosure may be filled (or at least partially filled) with the insulating liquid such that the components of the converter cell module which are arranged inside the enclosure are submerged within the insulating liquid.

The enclosure may be configured to withstand exposure to outdoor environmental conditions. Outdoor environmental conditions may comprise, for example, heat, cold, rain, snow, wind, humidity, pollution, radiation, and/or airborne particles. The converter cell module(s) may therefore withstand outdoor environmental conditions, which may increase the lifetime of an outdoor converter station comprising such converter cell module(s).

In some embodiments, the enclosure may comprise a metal. The metal may be a stainless metal. The metal may comprise, for example, steel, stainless steel, painted steel and aluminum. The metal may comprise corrosion coating. For example, the metal may comprise corrosion coated aluminum.

The connectors may include electrically insulating bushings arranged through the enclosure. The electrically insulating bushings may comprise resin, silicone rubber, or porcelain. By the term "electrically insulating bushing", it is further meant, for example, a hollow electrical insulator. The electrically insulating bushings may be configured to provide electrical insulation up to an overvoltage of the converter cell module. The electrically insulating bushing may be configured to provide electrical insulation up to an overvoltage between two converter cell modules or a potential between a grounding surface and a converter cell module. For example, the electrically insulating bushing may be configured to provide electrical insulation up to the highest value of the overvoltage between two converter cell modules or the potential between a grounding surface and a converter cell module.

In other embodiments, the enclosure may comprise an electrically insulating material. The electrically insulating material may comprise silicone rubber or porcelain. The enclosure comprising electrically insulating material may be understood as, for example, an insulation chamber.

The connectors may comprise metal. The connectors may be configured as flanges arranged through the enclosure, wherein the enclosure comprises an electrically insulating material.

The converter cell module may further comprise a pressure release element configured to release pressure created within the enclosure upon a malfunction of a component of the converter cell module. The pressure release element may comprise a pressure release valve. The pressure release element may reduce the risk of explosion of a converter cell module, which in turn may lead to a more reliable converter.

The enclosure may have a volume in the range of 0.2 to 0.5 cubic meters. The enclosure may have a volume in the range of 0.3 ± 15% cubic meters. However, the enclosure may have a volume which is less than 0.2 cubic meters. The enclosure may for example have dimensions of 0.7m ± 15% x 0.4m ± 15% x 1.1m ± 15%.

The converter cell modules of the valve may be electrically insulated from each other by ambient air. In other words, the converter cell modules of the valve may be spaced apart at a predetermined distance, with ambient air between the converter cell modules. The predetermined distance may be determined based on the required electrical insulation and the insulation properties of the ambient air.

For the second aspect, the electrical insulation may allow for converter cell modules to be arranged closer together than if air, or gas, was acting as the exterior electrical insulation medium between converter cell modules. Thereby, the footprint of the converter may be reduced.

The power converter arrangement may further comprise electrical connections for electrically connecting converter cell modules. The electrical connections may be configured to withstand exposure to outdoor environmental conditions.

The power converter arrangement may further comprise a conduit system connected between the plurality of converter cell modules. The conduit system may be configured for transporting cooling fluid to and from the converter cell modules and/or for providing cables establishing communication links between the converter cell modules.

It is noted that other embodiments using all possible combinations of features recited in the above described embodiments may be envisaged. Thus, the present disclosure also relates to all possible combinations of features mentioned herein. Any embodiment described herein may be combinable with other embodiments also described herein, and the present disclosure relates to all combinations of features.

### Brief description of the drawings

Exemplifying embodiments will be described below with reference to the accompanying drawings, in which:
Figures 1a and 1b are schematic views of a converter cell module;
Figures 2 and 3 are schematic views of converter cell modules;
Figures 4 to 6 are schematic views of power converter arrangements.
Figure 7 illustrates a switching module 740 and an electrical energy storage 720 module of a converter cell module.

All the figures are schematic, not necessarily to scale, and generally only show parts which are necessary in order to elucidate embodiments of the present invention, wherein other parts may be omitted or merely suggested. Like reference numerals refer to like elements throughout.

### Detailed description

The present invention will now be described hereinafter with reference to the accompanying drawings, in which exemplifying embodiments are shown. The present inventive concept may, however, be embodied in many different forms and should not be construed as limited to the embodiments set forth herein; rather, these embodiments are provided by way of example so that this disclosure will convey the scope of the invention to those skilled in the art. In the drawings, identical reference numerals denote the same or similar components having a same or similar function, unless specifically stated otherwise.

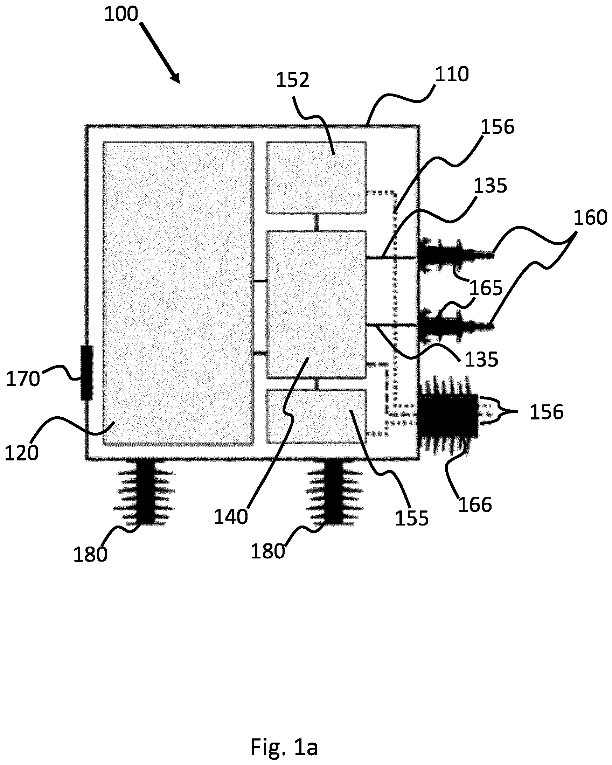

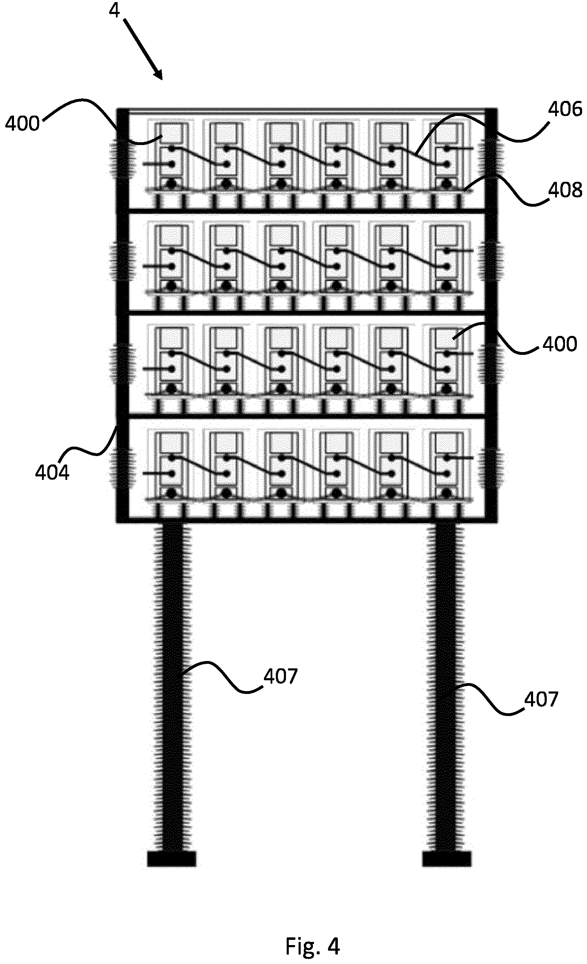

Figure 1a is a schematic side view of a converter cell module 100 according to an exemplary embodiment. The converter cell module 100 may be configured for a power converter arrangement (not shown; see Figures 4 to 6) of a High Voltage Direct Current, HVDC, transmission system or a Flexible Alternating Current Transmission System, FACTS, wherein the power converter valve includes a plurality of converter cell modules 100 electrically connected to each other.

The converter cell module 100 comprises an enclosure 110. The enclosure 110 is at least partially filled with an insulation fluid (not shown). The converter cell module 100 comprises an electrical energy storage medium 120 for storing energy associated with the converter cell module 100. The electrical energy storage medium 120 is arranged within the enclosure 110. The electrical energy storage medium 120 comprises a capacitor (not shown). It is to be understood that the electrical energy storage medium 120 may comprise a plurality of capacitors.

The converter cell module 100 further comprises a switching module 140, which is arranged within the enclosure 110. The switching module 140 comprises two (power) semiconductor switches electrically connected with the electrical energy storage module 120 in the form of a half-bridge circuit. However, the switching module 140 may comprise more than two semiconductor switches. For example, the switching module 140 may comprise four semiconductor switches electrically connected with the electrical energy storage module 120 in the form of a bridge circuit. The converter cell module 100 further comprises connectors 160 for electrical connection of electrical terminals 135 of the converter cell module 100 to at least another converter cell module (not shown, see Figures 4 to 6) of the power converter arrangement. The connectors 160 include electrically insulating bushings 165 arranged through the enclosure 110 and the electrical terminals 135 are connected to the connectors 160.

The switching module 140 is configured to connect the electrical energy storage medium 120 to the electrical terminals 135. The converter cell module 100 may further comprise a control unit 152, a protection unit 155, a DC/DC converter (not shown), communication means 156. The protection unit 155 may comprise a bypass switch and a resistor.

The control unit 152 is communicatively connected to at least another converter cell module via communication means 156. The control unit 152 is further configured to communicate with at least another converter cell module via the communication means 156.

The communication means 156 may comprise cables. The cables may comprise fiber optic cables. The communication means 156 for communicatively connecting the control unit 152 to at least another converter cell may be arranged through an auxiliary electrically insulating bushing 166 of the converter cell module 100. The auxiliary electrically insulating bushing 166 is arranged through the enclosure 110.

The control unit 152 may be communicatively connected to the switching module 140 and may be configured to control the switching module 140.

The control unit 152 may be communicatively connected to the bypass switch of the protection unit 155 and may be configured to control the bypass switch. The bypass switch may be configured to switch between a closed state, in which current and/or voltage may flow between the terminals 135 of the converter cell module 100 without passing any of the other electrical components of the converter cell module 100, and an opened state, in which current and/or voltage is directed towards the other electrical components of the converter cell module 100.

The converter cell module 100 may further comprise a DC/DC converter. The DC/DC converter may be connected to both sides of the electrical energy storage medium 120. The DC/DC converter may be connected to the control unit 152 and the switching module 140 and may be configured to supply DC power to the control unit 152 and the switching module 140. Hence, the control unit 152 and the switching module 140 may receive the power needed to operate via the DC/DC converter which in turns receives the power via the terminals 135 of the converter cell module 100.

The converter cell module 100 may further comprise a pressure release element 170 configured to release pressure created within the enclosure 110 upon a malfunction of the converter cell module 100. The pressure release element 170 may be arranged through the enclosure 110. The pressure release element 170 may comprise a pressure valve.

The insulation fluid is configured to provide electrical insulation within the enclosure 100 up to an overvoltage of the converter cell module 100. The insulation fluid may be a liquid. The enclosure 110 may be filled by an amount of insulation liquid such that all of the electrical components arranged within the enclosure 110 are submerged in the insulation liquid. However, the insulation fluid may alternatively be a gas. The gas may comprise at least one of pressurized air, synthetic air, CO₂, N₂, N₂-SF₆, CO₂-SF₆, or any combination thereof. Thereby, the components of the converter cell module 100 which are arranged within the enclosure 110 may be electrically insulated with regards to each other up to an overvoltage of the converter cell module, the overvoltage being higher than an operating voltage (or maximum design limit) of the power converter cell module and less than a voltage across the converter arrangement in which the converter cell module is to be installed.

The enclosure 110 is configured to withstand exposure to outdoor environmental conditions. The enclosure 110 may comprise a metal (material).

The converter cell module 100 may further comprise a plurality of mounting structures 180 arranged on a (bottom) side of the converter cell module 100, wherein two mounting structures 180 are shown in Figure 1a. The mounting structures 180 are configured as insulators.

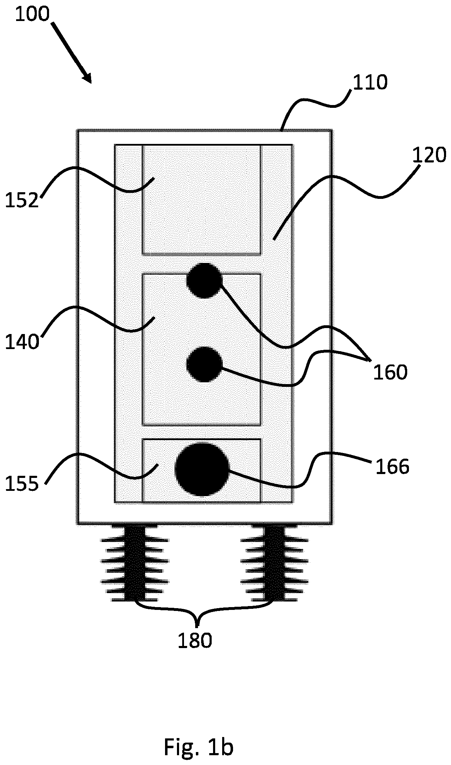

Figure 1b is a schematic front view of a converter cell module 100 according to an exemplary embodiment. Figure 1b shows a schematic front view of the converter module 100 of Figure 1a.

Figure 1b shows that the converter cell module 100 comprises additional mounting structures 180. It may be understood that the converter cell module 100 comprises four mounting structures 180, wherein two of them are shown in Figure 1b, while the remaining two are blocked from view by the two mounting structures 180 depicted in this figure. Further, Figure 1b shows that the electrical energy storage medium 120, the switching unit 140, the protection unit 155 and the control unit 152 are arranged at a distance from the sides, or walls, of the enclosure 110. Additionally, Figure 1b shows that the electrical energy storage medium 120, the switching unit 140, the protection unit 155 and the control unit 152 may be arranged centrally within the enclosure 110. Further, Figure 1b shows that the switching unit 140, the protection unit 155 and the control unit 152 may have a lesser extension in a horizontal direction than the electrical energy storage module 120.

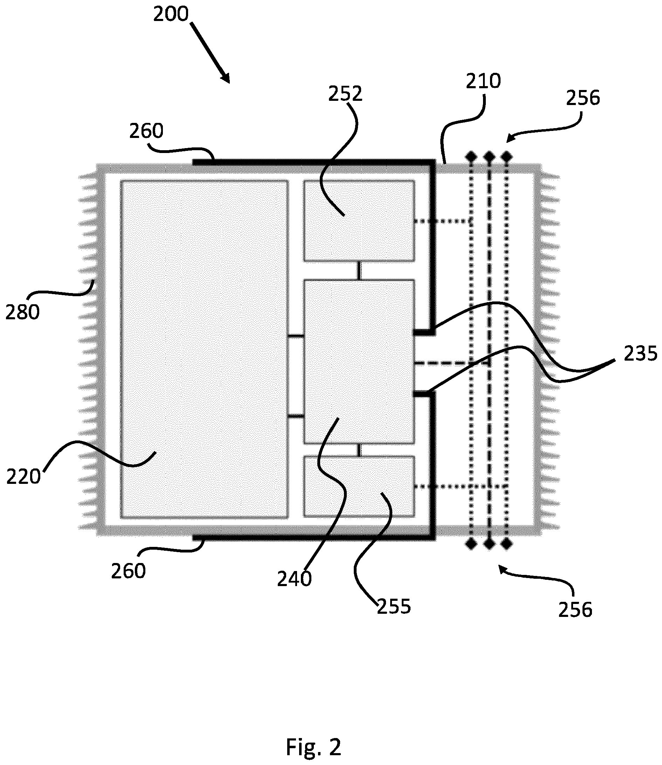

Figure 2 is a schematic side view of a converter cell module 200 according to an exemplary embodiment. The converter cell module 200 may be configured for a power converter arrangement (not shown; see Figures 4 to 6) of a High Voltage Direct Current, HVDC, transmission system or a Flexible Alternating Current Transmission System, FACTS, wherein the power converter valve includes a plurality of converter cell modules 200 electrically connected to each other.

The converter cell module 200 shown in Figure 2 is equivalent to the converter cell module 100 described above with reference to Figure 1a except that the enclosure is not made of a metal but of an electrically insulating material, and except that the connectors are not bushings extending through the enclosure but flanges, and that the communication means are not arranged through auxiliary electrically insulating bushings, as described in the following.

The converter cell module 200 comprises an enclosure 210. The enclosure 210 comprises an electrically insulating material. The enclosure 210 comprises sheds arranged on the outside of the enclosure 210. The sheds are configured to increase the electrically insulating properties of the enclosure 210. The enclosure 210 is at least partially filled with an insulation fluid (not shown). The converter cell module 200 comprises an electrical energy storage medium 220 for storing energy associated with the converter cell module 200. The electrical energy storage medium 220 is arranged within the enclosure 210. The electrical energy storage medium 220 comprises a capacitor (not shown). It is to be understood that electrical energy storage medium 120 may comprise a plurality of capacitors.

The converter cell module 200 further comprises a switching module 240, which is arranged within the enclosure 210. The switching module 240 comprises two (power) semiconductor switches electrically connected with the electrical energy storage module 220 in the form of a half-bridge circuit. However, the switching module 240 may comprise more than two semiconductor switches. For example, the switching module 240 may comprise four semiconductor switches electrically connected with the electrical energy storage module 220 in the form of a bridge circuit.

The converter cell module 200 further comprises connectors 260 for electrical connection of electrical terminals 235 of the converter cell module 200 to at least another converter cell module (not shown, see Figures 4 to 6) of the power converter arrangement. The connectors 260 are configured as flanges extending through the enclosure 210.

The switching module 240 is configured to connect the electrical energy storage medium 220 to the electrical terminals 235. The converter cell module 200 may further comprise a control unit 252, a protection unit 255, a DC/DC converter (not shown), and communication means 256. The protection unit 255 may comprise a bypass switch and a resistor.

The control unit 252 may be communicatively connected to at least another converter cell module via the communication means 256. The control unit 252 may be further configured to communicate with at least another converter cell module via the communication means 256.

The communication means 256 may comprises cable. The cables may comprise fiber optic cables. The communication means 256 for communicatively connecting the control unit 252 to at least another converter cell are arranged through sides of the enclosure 210. The communication means 256 are inside a hollow duct (not shown). The hollow duct is arranged through the enclosure 210. The hollow duct may further comprise cooling conduits or pipes.

The control unit 252 may be communicatively connected to the switching module 240 and may be configured to control the switching module 240.

The insulation fluid is configured to provide electrical insulation within the enclosure 200 up to an overvoltage of the converter cell module 200. The insulation fluid may be a liquid. The enclosure 210 may be filled by an amount of insulation liquid such that all of the electrical components arranged within the enclosure 210 are submerged in the insulation liquid. However, the insulation fluid may alternatively be a gas. The gas may comprise at least one of pressurized air, synthetic air, CO₂, N₂, N₂-SF₆, CO₂-SF₆, or any combination thereof. Thereby, the components of the converter cell module 200 which are arranged within the enclosure 210 may be electrically insulated with regards to each other up to an overvoltage of the converter cell module.

The enclosure 210 is configured to withstand exposure to outdoor environmental conditions.

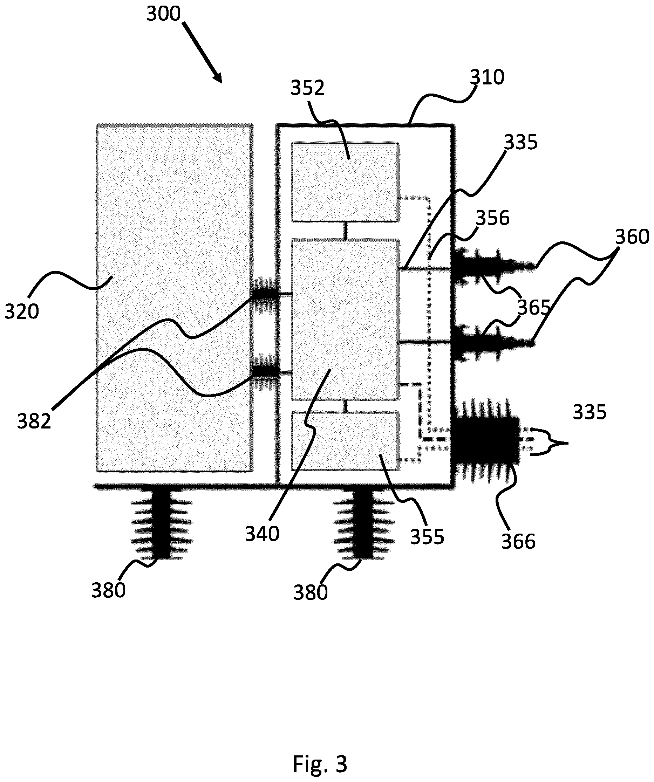

Figure 3 is a schematic side view of a converter cell module 300 according to an exemplary embodiment.

The converter cell module 300 shown in Figure 3 is equivalent to the converter cell module described above with reference to Figure 1a except that the electrical energy storage medium (or capacitor) of the converter cell module is not arranged within the enclosure of the converter cell module but outside of the enclosure, as described in the following.

The converter cell module 300 comprises an enclosure 310. The enclosure 300 is at least partially filled with an insulation fluid (not shown). The converter cell module 300 comprises a switching module 340, a control unit 352, a protection unit 355 and communication means 356. The switching module 340, the control unit 352, the protection unit 355 and the communication means 356 are arranged inside the enclosure 310.

The converter cell module 300 comprises an electrical energy storage medium 320 for storing energy associated with the converter cell module 300. The electrical energy storage medium 320 is arranged outside of the enclosure 310. The electrical energy storage medium 320 comprises a capacitor (not shown). It is to be understood that the electrical energy storage medium 320 may comprise a plurality of capacitors. The electrical energy storage medium 320 is electrically connected to the switching module 340 through power bushings 382. The power bushings 382 are arranged between the enclosure 310 and the electrical energy storage module 320.

The converter cell module 300 further comprise two connectors 360 arranged through the enclosure 310. The connectors 360 include electrically insulating bushings 365 arranged through the enclosure 310 and electrical terminals 335 of the converter cell module 300 are connected to the connectors 360.

The communication means 356 are arranged through an auxiliary electrically insulating bushing 366.

The converter cell module 300 further comprises a plurality of mounting structures 380 arranged on a (bottom) side of the converter cell module 300, wherein two mounting structures 380 are shown in Figure 3. The mounting structures 380 are configured as insulators.

Figure 4 illustrates a schematic view of a power converter arrangement 4 according to an exemplary embodiment.

The power converter arrangement 4 comprises a plurality of converter cell modules 400 electrically connected to each other. Each of the converter cell modules 400 may be equivalent to a converter cell module as described with reference to for example Figure 1a or Figure 3. The power converter arrangement 4 may comprise one or more power converter valves, wherein each power converter valve comprises a plurality of converter cell modules 400 electrically connected to each other.

The power converter arrangement 4 further comprises a structure (or supporting structure) 404 configured to support the plurality of converter cell modules 400. The structure 4 comprises four levels (or racks) arranged horizontally. The levels are connected to each other by segments arranged vertically. The segments comprise electrically insulating bushings, or sheds, arranged between the levels in order to electrically insulate the different levels of the arrangement 4 from one to another.

The structure 404 further comprises supporting elements 407. The supporting elements 407 comprise electrically insulating means or members. The supporting elements 407 are configured to provide electrical insulation between the power converter arrangement 4 and the ground (i.e. grounding surface). The supporting elements 407 may be configured to provide electrical insulation for a voltage up to several hundreds of kV. The electrical insulating means or members of the supporting elements 407 may comprise porcelain, resin and/or silicone rubber. The structure 404 may be configured to withstand exposure to outdoor environmental conditions.

The converter cell modules 400 are arranged in a stack of four layers wherein each layer comprises six converter cell modules 400 (each layer corresponding to a respective level of the structure 4). Hence, the power converter arrangement 404 comprises twenty-four converter cell modules 400. However, it is to be understood that this is only an example and the power converter arrangement 404 is not limited to such a number of converter cell modules 400 and to such a number of layers. The power converter arrangement 404 may comprise any number of power converter cell modules 400, arranged in a stack of any number of layers.

The converter cell modules 400 have different electrical potentials, thereby forming a converter.

The power converter arrangement 4 may comprise electrical connections 406 for electrically interconnecting the converter cell modules 400. Each electrical connection 406 is connected between connectors 160, 360 of two neighbouring converter cell modules 400. The electrical connections 406 may be configured to withstand exposure to outdoor environmental conditions.

The converter cell modules 400 of a layer may be spaced apart from each other. Further, the layers of the stack are spaced apart by a clearance distance such that adjacent converter cell modules 400 are electrically insulated from each other by ambient air or the medium surrounding the converter cell modules.

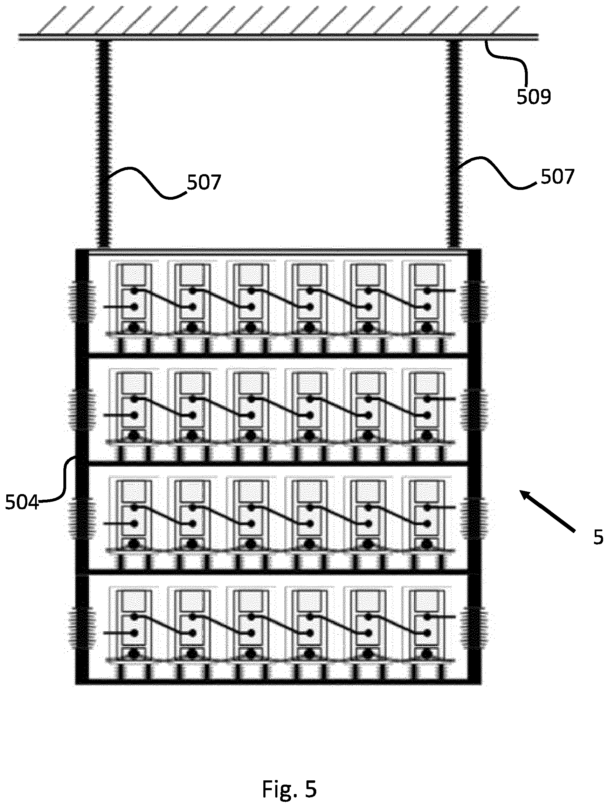

Figure 5 is a schematic view of a power converter arrangement 5 according to an exemplary embodiment. A difference between the power converter arrangement 5 shown in Figure 5 and the power converter arrangement 4 described above with reference to Figure 4 is that the structure 504 in Figure 5 is arranged in a hanging configuration, rather than in a standing configuration, as shown for structure 404 in Figure 4.

The power converter arrangement 5 comprises supporting elements 507. The supporting elements 507 are attached to a supporting system 509. The supporting system 509 may be, for example, a supporting frame or a building ceiling or frame. The supporting elements 507 may comprise electrically insulating means or members. The supporting elements 507 are configured to provide electrical insulation between the power converter arrangement 5 and the supporting system 509. The supporting elements 507 may be configured to provide electrical insulation for a voltage up to several hundreds of kV. The electrical insulation of the supporting elements 507 may be achieved by porcelain, resin and/or silicone rubber. The structure 5 may be configured to withstand exposure to outdoor environmental conditions, mechanical and seismic requirements.

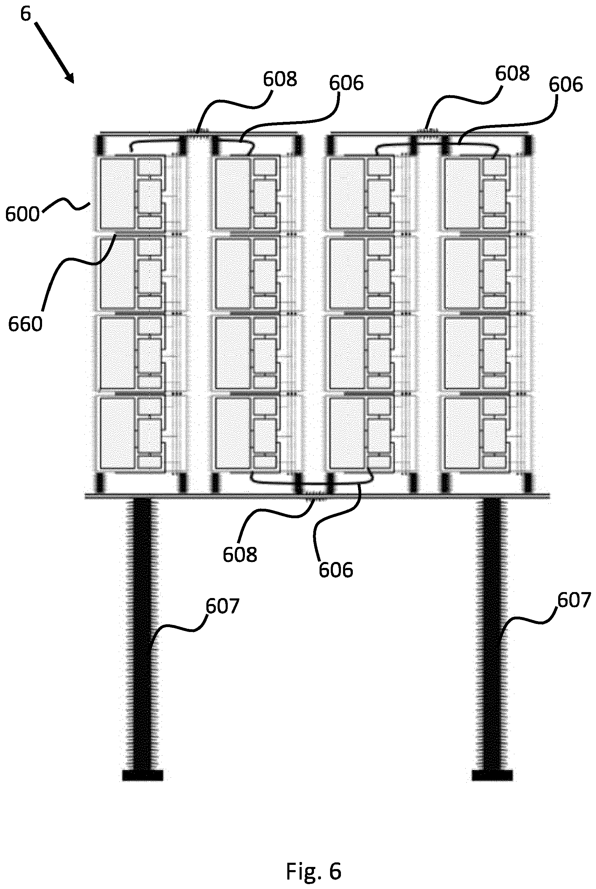

Figure 6 illustrates a schematic view of a power converter arrangement 6 according to an exemplary embodiment.

The power converter arrangement 6 comprises a plurality of converter cell modules 600 electrically connected to each other. Each of the converter cell modules 600 may be equivalent to a converter cell module as described with reference to for example Figure 2. The power converter arrangement 6 may comprise one or more power converter valves, wherein each power converter valve comprises a plurality of converter cell modules 600 electrically connected to each other.

The power converter arrangement 6 comprises four columns of converter cell modules 600. Each converter cell module 600 is connected to the converter cell module(s) 600 arranged above and/or below by flanges 660 of the connected converter cell modules 600. The two flanges 660 of a converter cell module 600 are arranged such that a flange at a top side of a first power converter cell module is adapted to mate with, or to at least electrically connect, with a flange at a bottom side of a second power converter module. In a more specific example, the two flanges of a power converter cell module 600 may be arranged substantially flush with a top side and a bottom side, respectively, of the converter cell module 600. The two flanges may for example be disposed parallel to each other, one at the bottom side and another one at the top side of the power converter cell module. Thereby, the flanges 660 allow for electrical connection between converter cell modules 600 by arranging them on top of each other. The different columns of converter cell modules 600 are interconnected (or electrically connected) by connecting the flanges 660 of two converter cell modules 600 arranged at the top, or bottom, of their respective column of converter cell modules 600 by electrical connections 606, which may for example be in the form of an electrical cable or wire. The electrical connections 606 may be configured to withstand exposure to outdoor environmental conditions. The electrical connections 606 may comprise power busbars. The power converter arrangement 6 shown in Figure 6 comprises three electrical connections 606, wherein each electrical connection 606 is arranged between two neighboring columns of converter cell modules 600.

The power converter arrangement 6 further comprises three auxiliary connections 608. The auxiliary connections 608 are configured to connect the communication means of neighboring columns of converter cell modules 600.

The power converter arrangement 6 further comprises supporting elements 607. The supporting elements 607 comprise electrically insulating means or members. The supporting elements 607 are configured to provide electrical insulation between the power converter arrangement 6 and the ground (i.e. electrical grounding). The supporting elements 607 may be configured to provide electrical insulation for a voltage up to several hundreds of kV. The electrical insulation of the supporting elements 607 may be achieved by porcelain, resin and/or silicone rubber. The power converter arrangement 6 may be configured to withstand exposure to outdoor environmental conditions.

It is to be understood that the power converter arrangement 6 is not limited to supporting members 607 arranged in a standing configuration, and may also be arranged in a hanging configuration, as disclosed in the above with regards to the difference between the power converter arrangement 4 of Figure 4 and the power converter arrangement 5 of Figure 5.

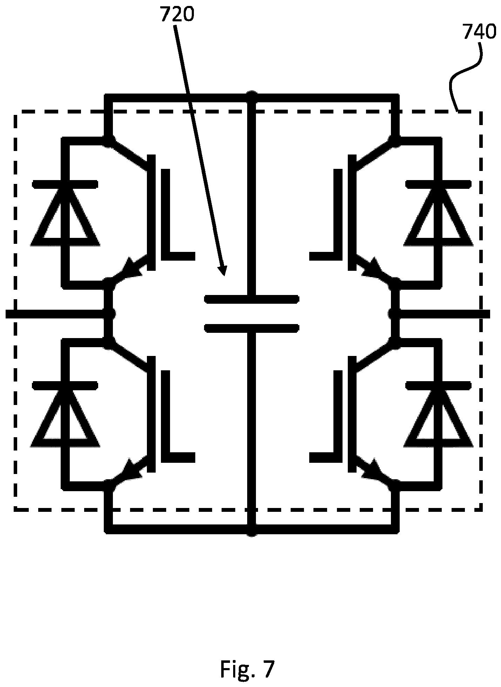

Figure 7 illustrates a switching module 740 and an electrical energy storage 720 module of a converter cell module. The switching module 740 includes four insulated-gate bipolar transistors (IGBTs) in an H-bridge configuration, freewheeling diodes connected across the IGBTs, or other type of switching components with both turn on and turn off capability. The IGBTs are electrically connected to the electrical energy storage 720. The electrical energy storage 720 is a capacitor.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A converter cell module (100-600) for a power converter valve of a High Voltage Direct Current, HVDC, transmission system or a Flexible Alternating Current Transmission System, FACTS, wherein the power converter valve includes a plurality of converter cell modules electrically connected to each other, the converter cell module comprising:
an enclosure (110, 210, 310) at least partially filled with an insulation fluid,
an electrical energy storage medium (120, 220, 320) for storing energy associated with the converter cell module,
connectors (160, 260, 360, 660) arranged through the enclosure and configured for electrical connection of electrical terminals of the converter cell module to at least another converter cell module of the valve, and
a switching module (140, 240, 340) arranged to connect the electrical energy storage medium to the electrical terminals, wherein at least the switching module is arranged within the enclosure,
wherein the insulation fluid is configured to provide electrical insulation within the enclosure up to an overvoltage of the converter cell module, wherein the overvoltage is higher than an operating voltage of the converter cell module and lower than a voltage across the power converter valve.

2. A converter cell module according to claim 1, wherein the electrical energy storage medium is a capacitor and the switching module includes at least two power semiconductor switches electrically connected with the capacitor in the form of a half-bridge or full-bridge circuit.

3. A converter cell module according to claim 1 or 2, wherein the electrical energy storage medium is arranged within the enclosure.

4. A converter cell module according to any one of the preceding claims, further comprising at least one of a control unit (152, 252, 352) configured to control the switching module, a bypass switch , a DC/DC converter, communication means (156) for communicating with at least another converter cell module, and a resistance.

5. A converter cell module according to any of the preceding claims, wherein the insulation fluid is a gas comprising at least one of pressurized air, synthetic air, CO₂, N₂, N₂-SF₆, CO₂-SF₆, or any combination thereof.

6. A converter cell module according to any of claims 1 to 5, wherein the insulation fluid is a liquid.

7. A converter cell module according to any of the preceding claims, wherein the enclosure is configured to withstand exposure to outdoor environmental conditions.

8. A converter cell module according to any of the preceding claims, wherein the enclosure comprises a metal.

9. A converter cell module according to claim 8, wherein the connectors include electrically insulating bushings (165, 365) arranged through the enclosure.

10. A converter cell module according to any of claim 1 to 7, wherein the enclosure comprises an electrically insulating material.

11. A converter cell module according to any of the preceding claims, further comprising a pressure release element (170) configured to release pressure created within the enclosure upon a malfunction of the converter cell module.

12. A converter cell module according to any one of the preceding claims, wherein the enclosure has a volume in the range of 0,2 to 0,5 cubic meters.

13. A power converter arrangement (1, 2) comprising:
a valve comprising a plurality of converter cell modules (100-600) as defined in any of the preceding claims, said plurality of converter cell modules being electrically connected to each other; and
a structure (404, 504) configured to support the plurality of converter cell modules at a distance from a grounding surface.

14. A power converter arrangement according to claim 13, wherein the converter cell modules of the valve are electrically insulated from each other by ambient air.

15. A power converter arrangement according to any one of claims 13-14, further comprising electrical connections (406) for electrically connecting converter cell modules, wherein said electrical connections are configured to withstand exposure to outdoor environmental conditions.

16. A power converter arrangement according to any one of claims 13-14, further comprising a conduit system connected between the plurality of converter cell modules, wherein the conduit system is configured for delivering cooling fluid to the converter cell modules and/or for providing cables establishing communication links between the converter cell modules.
